# EUROPEAN PATENT SPECIFICATION

(11) **EP 0 969 286 B1**
(45) Date of publication and mention of the grant of the patent: **12.09.2007**
(21) Application number: 99610037.6
(22) Date of filing: 02.07.1999
(51) Int. Cl.: G01R 21/133, G01R 35/00, G01R 21/06

(54) **An apparatus for the determination of electrical power and a method of testing or calibrating a plurality of such apparatus**
Elektrisches Leistungserfassungsgerät und Verfahren zur Prüfung oder Eichung mehrerer solcher Geräte
Appareil de mesure de puissance électrique et procédé de test ou d'étallonage d'une pluralité de tels appareils

(30) Priority: 03.07.1998 DK 87198; 17.12.1998 DK 166098
(43) Date of publication of application: 05.01.2000
(73) Proprietor: KAMSTRUP A/S, 8660 Skanderborg (DK)
(72) Inventor: Sorensen, Jens Drachmann, 8000 Aarhus C (DK)
(74) Representative: Plougmann & Vingtoft A/S

(56) References cited:
- US-A- 4 839 819
- US-A- 5 196 982
- US-A- 5 539 304
- US-A- 5 701 253
- US-A- 5 920 189

## Description

The present invention relates to an apparatus for determining electrical power supplied by an electrical power supply system comprising a plurality of phases and using shunt resistors. The invention also relates to a method of testing or calibrating such an apparatus or a plurality of such apparatus.

In the field of electrical power measurement shunt resistors have been widely used for the generation of an electrical representation of the current supplied by a power supply system. A shunt resistor connected in series with a phase in a power supply system provides a linear and highly sensitive method of generating a voltage proportional to the current supplied by the phase. Having information regarding the voltage potential of the phase the power supplied by the phase can be determined.

A disadvantage of using shunt resistor is related to the fact, that measurement circuit connected to the shunt resistor is drawn to the voltage potential of the phase.

In DE 27 15 283 a power measurement system for the determination of the power supplied by a multi-phase power supply system is disclosed. The system disclosed in DE 27 15 283 has for each phase a shunt resistor connected in series with the phase for the generation of a voltage proportional to the current supplied by that phase. Further, the system disclosed in DE 27 15 283 comprises in each phase an electrical circuit for determining the voltage of the phase.

To determine the power supplied by a given phase, the voltage representing the current and the determined voltage of the phase are multiplied so as to generate a current which is proportional to the product of the current and the voltage supplied by the phase. Thus, this generated current constitutes an electrical representation of the power supplied by the phase.

For the determination of the total power supplied by the electrical power supplying system, i.e. the sum of the power supplied by all phases, each of the electrical representations of the power supplied by each phase is transmitted to a central unit via e.g. opto-couplers. This unit consists of a step-motor and a counter, whereby the total current supplied by the power system can be determined.

It is a disadvantage of the system described in DE 27 15 283 that the shunt resistor and the electrical circuit for determining the voltage potential of a given phase are both constantly galvanically connected to the phase, whereby testing or calibration of the current sensing means (shunt resistor) and voltage sensing means (electrical circuit) can not be carried out independently of each other.

It is a further disadvantage of the system disclosed in DE 27 15 283 that only a single apparatus can be tested or calibrated at the same time making testing and calibration expensive and very time consuming.

It is a still further disadvantage of the system disclosed in DE 27 15 283 that during testing and calibration, the operating voltages and currents are used, which results in high power consumption.

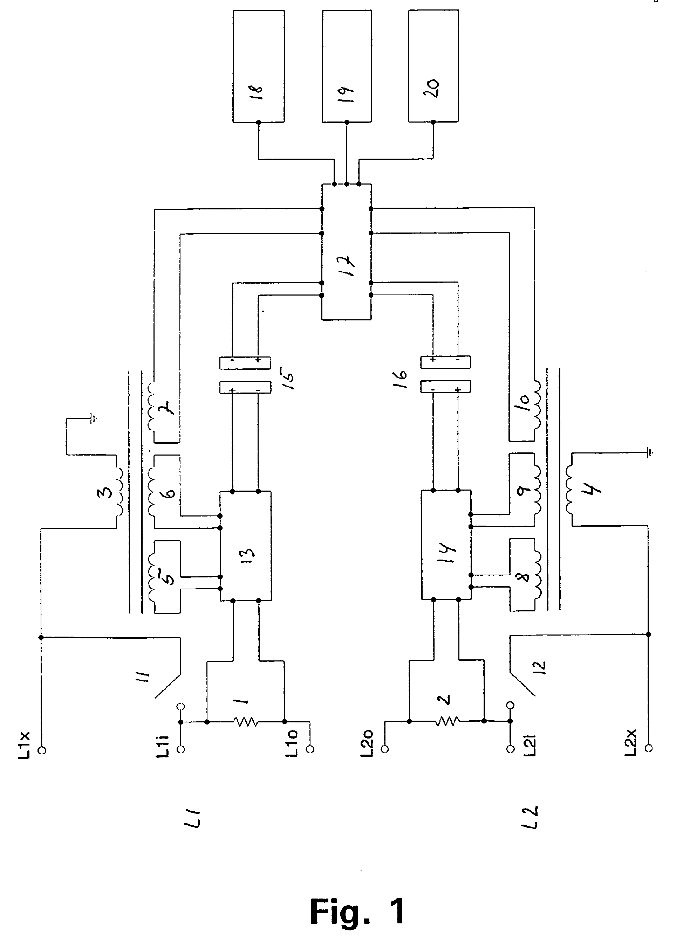

US 5,701,253 discloses in Figs. 1 a polyphase power meter for determining electrical power supplied by an electrical power supply system. The apparatus has power shunt resistors 12a-12c for each electrical phase A, B, C thus converting current delivered by each phase to corresponding voltages. A signal processing circuit 22 is connected to receive the voltages from the shunt resistors 12a-12c together with voltages from voltage dividers 24a-24c sensing voltages delivered by each phase. The shunt resistors 12a-12c are connected to the signal processing circuit 12 via respective isolation devices 20a-20c, e.g. isolation capacitors, to ensure that high voltage potentials from the shunt resistors 12a-12c do not reach the signal processing circuit 22.

US 5,539,304 discloses a power meter with a voltage to frequency converter 4 for generating a pulse train in response to a current sensed by a shunt resistor 2. Another voltage to frequency converter 5 generates a pulse train in response to a sensed voltage. Respective opto-isolators 6, 7 serve as galvanic separation between the respective frequency converters 4, 5 and inputs of a processor 8. US 5,539,304 also discloses a method of calibrating such power meter.

US 5,920,189 discloses a current monitor based on a shunt resistor R₁₀ for generating a voltage corresponding to a current I_{L} through a load 32.

US 4,839,819 discloses a power meter for a machine tool based on a shunt resistor 40 for sensing a current through a motor 34 of the tool.

It is an object of the present invention to solve the above-mentioned problem so as to provide an apparatus for determining of the electrical power and using shunt resistors where testing or calibration of the current sensing means (shunt resistor) and voltage sensing means (electrical circuit) can be carried out independently of each other.

Also, it is an object of the present invention to provide a type of apparatus which allows simultaneous testing and calibrating of a plurality thereof.

Thus, in a first aspect, the invention relates to an apparatus for determining electrical power supplied by an electrical power supply system having at least two phases, the device comprising:
for each phase:
- a current sensing means comprising:
   - input and output terminals for receiving the phase from the electrical power supply system and for outputting it to a user, and
   - at least one shunt resistor connected between the input and output terminals so as to generate over the shunt resistor a first voltage proportional to current supplied by the phase,
- means for sensing a voltage supplied by the phase, the voltage sensing means comprising a voltage input, and
- means for determining, from the first voltage and the sensed voltage, a power supplied by the phase,
the apparatus also comprising a central power calculating unit for determining, from the determined powers supplied by the at least two phases, a total power supplied by the electrical power supply system,
where the apparatus further comprises, for each of the at least two phases, means for galvanically separating the current sensing means and the input of the voltage sensing means, characterized in that
the separating means are adapted to assume one of two modes, a first mode being a mode where galvanic separation is provided and the second mode being a mode where a galvanic connection is provided between the input, output or shunt resistor of the current sensing means and the input of the voltage sensing means.

In the present context, the term "phase" will be used for both the voltage/current provided by the phase and to designate the elements used to determine these quantities during normal operation, even though they may not be used for determining corresponding voltages and currents during calibration or test.

Introducing the possibility of galvanically separating the current sensing means and the input of the voltage sensing means provides the possibility of separately testing and calibrating these two sensing means, even though the current sensing will be at a potential corresponding to that of the current provided.

However, during normal operation, it is required that the voltage of the phase being provided to the shunt resistor is also provided to the voltage sensing means - that is, that there is a galvanic connection to the voltage sensing means.

In that situation, under normal operation, the voltage sensing means would be adapted to receive a voltage from the input, output or shunt resistor of the current sensing means, when the separation means are in the second mode.

Thus, when the apparatus further comprises an additional input for receiving a predetermined voltage, the voltage sensing means can be adapted to receive the predetermined voltage when the separation means are in the first mode, as they are then galvanically separated from the shunt resistor.

In that manner, the separating means will be adapted to define in which of these two modes of operation the apparatus acts.

The separating means to define in which of the above-mentioned two modes of operation the apparatus acts may be a switch.

Preferably, the apparatus further comprises, for at least one phase, means for transmitting the determined power supplied from the determining means of the at least two phases to the central calculating unit, each transmitting means comprising means, such as an opto-coupler, for galvanically separating the determining means and the central calculating unit, as the determining means will be at the potentials of the individual phases, and the final calculation is performed at a single given potential.

In an interesting embodiment, the voltage sensing means of at least one phase comprises a voltage transformer having a primary winding and a first secondary winding, the primary winding receiving the voltage to be determined from the input of the voltage sensing means, the voltage sensing means being adapted to determine the voltage from a voltage generated in the first secondary winding. One advantage of this transformer is that it in itself provides a permanent galvanic separation between the primary and secondary windings while still providing there-across a measure of the voltage of the phase. This may be utilized when separating the voltage sensing means and the current sensing means during calibration and test. The voltage generated in the secondary winding will be proportional to that in the primary winding but will be galvanically separated, whereby it may be drawn to any absolute voltage potential - such as that to which the shunt resistor experiences - independently of the absolute potential of the primary winding. This effect is taken advantage of during calibration, where the primary winding may be at the potential of normal operation of the apparatus, but where that of the shunt resistor may be substantially lower.

A further way of taking advantage of the voltage transformer is to have it further comprise a second secondary winding for power feeding the determining means of the at least one phase. When the voltage of the primary winding is typically known during normal operation, the second secondary winding may be chosen to generate the voltage required by the determining means. Also, as mentioned above, the absolute voltage of the primary winding is not imposed on the determining means via the transformer. Again this fact is used especially during calibration and test.

Also, using the same effect, the voltage transformer may further comprise a third secondary winding for power feeding the central calculating unit. The potential of the central unit is not influenced on those of the primary winding and the other secondary windings.

Due to the galvanic separation of the secondary windings, secondary windings on the same voltage transformer may power feed all determining means and the central calculating unit. However, as at least the determining means will be at different potentials due to the shunt resistors, different secondary windings will be provided for each. However, at present, it is desired that each determining means is power fed by a secondary winding of the transformer of the voltage sensing means of the corresponding phase.

In another interesting embodiment, the voltage sensing means of at least one phase comprises a differential amplifier being adapted to transform a voltage difference from a first voltage level to a second voltage level.

Naturally, it is desired that the resistivity of the shunt resistor is as small as possible while still retaining measuring accuracy. Thus, preferably the resistivity of the shunt resistor is in the range from 0.000001 ohms to 1 ohms, such as in the range from 0.00001 ohms to 0.1 ohms, preferably in the range from 0.0001 ohms to 0.01 ohms.

In another aspect, the invention relates to a method of operating the above apparatus where the separating means is adapted to assume one of the two modes, the method comprising:
- for each of the at least two phases, when the separating means are in their first mode:
   - providing a predetermined voltage to the input of the voltage sensing means and calibrating or testing the voltage sensing means, and/or
   - providing a predetermined current through the shunt resistor of the current sensing means and calibrating or testing the current sensing means, and
- when the separating means are in their second mode:
   - for each phase:
      - providing a voltage and current through the phase,
      - sensing the current using the current sensing means,
      - sensing the voltage using the voltage sensing means,
      - determining, using the power determining means, the power supplied by the phase,
   - determining, using the central power calculating unit, the total power supplied by the at least two phases.

One type of test may simply be that of ensuring that the voltage and current sensing means as well as the determining means perform their operations.

Naturally, the output of the voltage and current sensing means will vary with a number of parameters, where some will vary between different apparatus. Therefore, a calibration will be required. Calibration parameters or data will be required in order to correctly transform these outputs to a measure of the power supplied by the phase. This correction may be performed anywhere suitable.

In one situation, the correction is performed in the individual determining means and in another situation in the central unit, whereby the calibration or testing might comprise, for each phase,
- analysing the output of the power determining means, determining,
- generating, on the basis of the analysis calibrating or testing data,
- using the calibrating or testing data in the power determining means or the central calculating unit, and
- introducing the generated data in the power determining means or the central calculating unit - for subsequent correction and therefore output of the correct power.

Normally, the predetermined voltage used during test or calibration will be similar to that of the phase during normal operation, that is, in the range of 105-500V, such as in the range of 105-125V or in the range of 230-250V.

Also, normally the predetermined current will be similar to that of the phase during normal operation, which may be in the range of 25mA - 80A.

An advantage of the present invention is the fact that it is possible to, during test or calibration, provide the predetermined current at a voltage independent from the predetermined voltage.

In the following, a preferred embodiment will be described with reference to the drawing, wherein Fig. 1 illustrates a schematic diagram of the present invention. For simplicity, an apparatus for determining the power supplied by a two-phase system is shown.

To determine the power supplied by a phase in a power supply system, information regarding the current and the voltage potential of the phase is required.

To determine the current in a phase L1 a shunt resistor 1 is connected in series with the phase so as to generate a voltage proportional to the current supplied by that phase. The resistivity of the shunt resistor 1 is typically in the order of 10⁻⁶ ohms. The voltage generated over the shunt resistor 1 is transmitted to a power measuring unit 13.

In order to determine the power supplied by the phase, information regarding the voltage potential of the phase is required. To obtain this information a voltage transformer comprising at least one primary 3 and at least one secondary windings 5 to 7 is used. Specifically a voltage transformer having one primary winding 3, a first secondary winding 5, a second secondary winding 6 and a third secondary winding 7 is used.

The primary winding 3 of the voltage transformer is connected between the phase Lli and neutral for standard operation mode via the switching means Sk1.

For test or calibration the primary winding 3 of the voltage transformer is connected between a test voltage Llx and neutral. In the test or calibration mode the switching means Skl are disconnected.

The output signal of the first secondary winding 5 provides the power measuring unit 13 with the determined voltage of the phase L1.

The output signal of the second secondary winding 6 powers the power measuring unit 13.

The output signal of the third secondary winding 7 powers the central calculating unit 17.

In a preferred embodiment of the present invention, the power measuring unit 13 operates at or near the voltage potential of the phase to which it is directly connected via the shunt resistor.

The power measuring unit 13 receives at least a first and a second input signal.

The first input signal to said power measuring unit 13 is the voltage generated over the shunt resistor 1 which is an electrical representation of the current supplied by the phase. The second input signal is the output signal from the first secondary winding 5 of the voltage transformer which is an electrical representation of the voltage potential of the phase.

Applying an appropriate algorithm comprising the product between the two input signals representing the current and the voltage potential the phase, the power supplied by said phase may be determined.

In order to calculate the total power supplied by an electrical system comprising a plurality of phases, the output signals from the power measuring units 13 operating at or near the voltage potentials of the plurality of phases are transmitted to a central calculating unit 17 preferably operating at or near neutral.

Since the transmitted signals to the central power calculating unit 17 are generated at voltage levels typically separated by several hundreds of volts opto-couplers 15 are inserted the transmission links between the power measuring units 13 and the central calculating unit 17. The central calculating unit is preferably powered by the output signal from the third secondary winding 7 of the voltage transformer.

The central calculating unit 17 may comprise visual indicators 18 to 20 concerning the power supplied in each phases or all phases.

During the above description reference has only been made to one of the phases L1 in Fig. 1. However, one should know that an exact identical description could also be made with reference to with other phase L2 in Fig. 1.

## Claims

1. An apparatus for determining electrical power supplied by an electrical power supply system having at least two phases (L1, L2), the apparatus comprising:
for each phase (L1) :
- a current sensing means comprising:
- input and output terminals (L1i, L1o) for receiving the phase from the electrical power supply system and for outputting it to a user, and
- at least one shunt resistor (1) connected between the input and output terminals (L1i, L1o) so as to generate over the shunt resistor (1) a first voltage proportional to current supplied by the phase (L1),
- means (3, 5) for determining a voltage supplied by the phase (L1), the voltage sensing means comprising a voltage input, and
- means (13) for determining, from the first voltage and the determined voltage, a power supplied by the phase (L1),
the apparatus also comprising a central power calculating unit (17) for determining, from the determined powers supplied by the at least two phases (L1, L2), a total power supplied by the electrical power supply system,
the apparatus further comprises, for each of the at least two phases (L1, L2), means (11, 12) for galvanically separating the current sensing means (1, 2) and the input of the voltage sensing means,
**characterised in that** the separating means (11, 12) are adapted to assume one of two modes, a first mode being a mode where galvanic separation is provided and a second mode being a mode where a galvanic connection is provided between the input (L1i, L2i), output (Llo, L2o) or shunt resistor (1, 2) of the current determining means and the input of the voltage sensing means.

2. An apparatus according to claim 1, the apparatus further comprising an additional input (L1x, L2x) for receiving a predetermined voltage, the voltage sensing means being adapted to receive the predetermined voltage when the separation means (11, 12) are in the first mode.

3. An apparatus according to claim 1 or 2, wherein the voltage sensing means are adapted to receive a voltage from the input (L1i, L2i), output (L1o, L2o) or shunt resistor (1, 2) of the current sensing means, when the separation means (11, 12) are in the second mode.

4. An apparatus according to any of the preceding claims, further comprising, for at least one phase, means for transmitting the determined power supplied from the determining means (13, 14) of the at least two phases (L1, L2) to the central calculating unit (17), each transmitting means comprising means (15, 16), such as an opto-coupler, for galvanically separating the determining means (13, 14) and the central calculating unit (17).

5. An apparatus according to any of the preceding claims, wherein the voltage sensing means (3, 5) of at least one phase comprises a voltage transformer having a primary winding (3) and a first secondary winding (5), the primary winding (3) receiving the voltage to be determined from the input (L1i) of the voltage sensing means, the voltage sensing means being adapted to determine the voltage from a voltage generated in the first secondary winding (5).

6. An apparatus according to claim 5, wherein the voltage transformer further comprises a second secondary winding (6) for power feeding the determining means (13) of the at least one phase (L1).

7. An apparatus according to claim 5 or 6, wherein the voltage transformer further comprises a third secondary winding (7) for power feeding the central calculating unit (17).

8. An apparatus according to any of the preceding claims, wherein the voltage sensing means of at least one phase (L1) comprises a differential amplifier being adapted to transform a voltage difference from a first voltage level to a second voltage level, the differential amplifier having at least one input terminal being adapted to receive the voltage difference to be determined from the input of the voltage sensing means, the voltage sensing means being adapted to determine the voltage from a voltage generated by the differential amplifier.

9. An apparatus according to any of the previous claims, wherein the resistivity of the shunt resistor (1, 2) is in the range from 0.000001 ohms to 1 ohms, such as in the range from 0.00001 ohms to 0.1 ohms, preferably in the range from 0.0001 ohms to 0.01 ohms.

10. An apparatus according to claim 1, wherein the separating means (11) comprise a switch having two modes of operation, one providing a galvanic connection between the inputs (L1i, L1x) and one where the inputs (L1i, L1x) are galvanically separated.

11. A method of operating the apparatus according to any of the preceding claims, the method comprising:
- for each of the at least two phases, when the separating means are in their first mode:
- providing a predetermined voltage to the input of the voltage sensing means and calibrating or testing the voltage sensing means, and/or
- providing a predetermined current through the shunt resistor of the current sensing means and calibrating or testing the current sensing means, and
- when the separating means are in their second mode:
- for each phase:
- providing a voltage and current through the phase,
- determining the current using the current sensing means,
- determining the voltage using the voltage sensing means,
- using the power determining means, determining the power supplied by the phase,
- determining, using the central power calculating unit, the total power supplied by the at least two phases.

12. A method according to claim 11, wherein the calibration comprises, for each phase,
- analysing the output of the current and voltage sensing means,
- generating on the basis of the analysis calibrating data,
- using the calibrating data in the power determining means or the central calculating unit,
- introducing the generated data in the power determining means or the central calculating unit.

13. A method according to claim 11 or 12, wherein the predetermined voltage is in the range of 105-500V, such as in the range of 105-125V or in the range of 230-250V.

14. A method according to any of claims 11-13, wherein the predetermined current is in the range of 25mA-80A.

15. A method according to any of claims 11-14, wherein the predetermined current is provided at a voltage independent from the predetermined voltage.

## Patentansprüche

1. Vorrichtung zur Bestimmung elektrischer Energie, die durch ein elektrisches Energieversorgungssystem mit mindestens zwei Phasen (L1, L2) bereitgestellt wird, wobei die Vorrichtung umfasst:
für jede Phase (L1):
- ein Stromsensormittel, umfassend:
- Eingangs- und Ausgangsanschlüsse (L1i, L10) zur Aufnahme der Phase aus dem elektrischen Energieversorgungssystem und zu dessen Ausgabe an einen Verbraucher, und
- mindestens einen Shuntwiderstand (1), der zwischen den Eingangs- und Ausgangsanschlüssen (L1i, L1o) geschaltet ist, um über dem Shuntwiderstand (1) eine erste Spannung zu erzeugen, die zum Strom, der durch die Phase (L1) bereitgestellt ist, proportional ist,
- Mittel (3, 5) zur Bestimmung einer durch die Phase (L1) bereitgestellten Spannung, wobei die Spannungssensormittel ein Spannungseingang umfassen, und
- Mittel (13) zur Bestimmung, von der ersten Spannung und der bestimmten Spannung, einer durch die Phase (L1) bereitgestellten Energie,
wobei die Vorrichtung auch eine zentrale Energierecheneinheit (17) zur Bestimmung umfasst, von den bestimmten, durch die mindestens zwei Phasen (L1, L2) bereitgestellten, Energien einer gesamten, durch das elektrische Energieversorgungssystem bereitstellten, Energie,
wobei die Vorrichtung weiterhin für jeden der mindestens zwei Phasen (L1, L2) Mittel (11, 12) zur galvanischen Trennung der Stromsensormittel (1, 2) und dem Eingang der Spannungssensormittel umfasst,
**dadurch gekennzeichnet, dass** die Trennmittel (11, 12) dafür geeignet sind, ein von zwei Betriebsarten anzunehmen, wobei die erste Betriebsart eine Betriebsart ist, wo galvanische Trennung vorgesehen ist, und eine zweite Betriebsart eine Betriebsart ist, wo ein galvanische Verbindung zwischen dem Eingang (L1i, L2i), dem Ausgang (L1o, L2o) oder dem Shuntwiderstand (1, 2) der Strombestimmungsmittel und dem Eingang der Spannungssensormittel vorgesehen ist.

2. Vorrichtung nach Anspruch 1, wobei die Vorrichtung weiterhin einen zusätzlichen Eingang (L1x, L2x) umfasst, um eine vorbestimmte Spannung zu erhalten, wobei die Spannungssensormittel geeignet sind, die vorbestimmte Spannung aufzunehmen, wenn sich die Trennungsmittel (11, 12) in der ersten Betriebsart befinden.

3. Vorrichtung nach Anspruch 1 oder 2, worin die Spannungssensormittel dafür geeignet sind, eine Spannung vom Eingang (L1i, L2i), dem Ausgang (L1o, L2o) oder dem Shuntwiderstand (1, 2) der Stromsensormittel aufzunehmen, wenn sich die Trennmittel (11, 12) in der zweiten Betriebsart befinden.

4. Vorrichtung nach irgendeinem der vorgehenden Ansprüche, weiterhin, für zumindest eine Phase, umfassend Mittel zum Weiterleiten der bestimmten Energie, die von den Bestimmungsmitteln (13, 14) der mindestens zwei Phasen (L1, L2) für die zentrale Recheneinheit (17) bereitgestellt werden, wobei jedes Übertragungsmittel Mittel (15, 16), wie einen Optokoppler, umfasst zur galvanischen Trennung der Bestimmungsmittel (13, 14) und der zentralen Recheneinheit (17).

5. Vorrichtung nach irgendeinem der vorhergehenden Ansprüche, worin die Spannungssensormittel (3, 5) von mindestens einer Phase einen Spannungstransformator mit einer primären Wicklung (3) und einer ersten sekundären Wicklung (5) umfassen, wobei die primäre Wicklung (3) die zu bestimmende Spannung aus dem Eingang (L1i) der Spannungssensormittel erhält, wobei die Spannungssensormittel geeignet sind, die Spannung aus einer Spannung, die in der ersten sekundären Wicklung (5) erzeugt ist, zu bestimmen.

6. Vorrichtung nach Anspruch 5, worin der Spannungstransformator weiterhin eine zweite sekundäre Wicklung (6) zur Energieeinspeisung in die vorbestimmten Mittel (13) der mindestens einen Phase (L1) umfasst.

7. Vorrichtung nach Anspruch 5 oder 6, worin der Spannungstransformator weiterhin eine dritte sekundäre Wicklung (7) zur Energieeinspeisung der zentralen Recheneinheit (17) umfasst.

8. Vorrichtung nach irgendeinem der vorhergehenden Ansprüche, worin die Spannungssensormittel der mindestens einen Phase (L1) einen Differenzverstärker umfassen, der geeignet ist, einen Spannungsunterschied von einem ersten Spannungsniveau zu einem zweiten Spannungsniveau zu übertragen, wobei der Differenzverstärker mindestens einen Eingangsanschluss hat, der geeignet ist, den Spannungsunterschied aufzunehmen, der von dem Eingang der Spannungssensormittel bestimmt werden soll, wobei die Spannungssensormittel geeignet sind, die Spannung einer durch einen Differenzverstärker erzeugten Spannung zu bestimmen.

9. Vorrichtung nach irgendeinem der vorhergehenden Ansprüche, worin der Leistungswiderstand des Shuntwiderstandes (1, 2) im Bereich von 0,000001 ohm zu 1 ohm liegt, wie im Bereich von 0,00001 ohm bis 0,1 ohm, vorzugsweise im Bereich von 0,0001 ohm bis 0,01 ohm.

10. Vorrichtung nach Anspruch 1, worin das Trennmittel (11) einen Schalter mit zwei Betriebsarten umfasst, eine, die eine galvanische Verbindung zwischen den Eingängen (L1i, L1x) vorsieht und eine, wo die Eingänge (L1i, L1x) galvanisch getrennt sind.

11. Verfahren zum Betrieb der Vorrichtung nach irgendeinem der vorhergehenden Ansprüche, wobei das Verfahren umfasst:
- für jede der mindestens zwei Phasen, wenn das Trennmittel sich in seiner ersten Betriebsart befindet:
- Bereitstellung einer vorbestimmten Spannung zum Eingang der Spannungssensormittel und Kalibrierung oder Prüfung der Spannungssensormittel, und/oder
- Bereitstellung eines vorbestimmten Stroms durch den Shuntwiderstand des Stromsensormittels und Kalibrierung oder Prüfung des Stromsensormittels, und
- wenn das Trennmittel sich in seiner zweiten Betriebsart befindet:
- fürjede Phase:
- Bereitstellung einer Spannung und eines Stroms durch die Phase,
- Bestimmung des Stroms bei Verwendung des Stromsensormittels,
- Bestimmung der Spannung bei Verwendung des Spannungssensormittels,
- Verwendung des Energiebestimmungsmittels, das die durch die Phase bereitgestellte Energie bestimmt,
- Bestimmung, bei Verwendung der zentralen Energierecheneinheit, der gesamten Energie, die durch die mindestens zwei Phasen bereitgestellt wird.

12. Verfahren nach Anspruch 11, worin die Kalibrierung für jede Phase folgendes umfasst,
- Analyse der Ausgabe des Strom- und Spannungssensormittels,
- Erzeugung auf der Basis der Analysekalibrierungsdaten,
- Verwendung der Kalibrierungsdaten in den Energiebestimmungsmitteln oder der zentralen Recheneinheit,
- Einführung der erzeugten Daten in das Energiebestimmungsmittel oder die zentrale Recheneinheit,

13. Verfahren nach Anspruch 11 oder 12, worin die vorbestimmte Spannung im Bereich von 105-500V liegt, wie im Bereich von 105-125V oder im Bereich von 230-250V.

14. Verfahren nach irgendeinem der Ansprüche 11-13, worin der vorbestimmte Strom im Bereich von 25mA-80A liegt.

15. Verfahren nach irgendeinem der Ansprüche 11-14, worin der vorbestimmte Strom bei einer Spannung unabhängig von der vorbestimmten Spannung vorgesehen wird.

## Revendications

1. Appareil servant à déterminer la puissance électrique fournie par un système d'alimentation électrique à minimum deux phases (L1, L2), l'appareil comprenant :
pour chaque phase (L1) :
- un capteur de courant comprenant :
- des bornes d'entrée et de sortie (L1i, L1o) pour la réception de la phase provenant du système d'alimentation électrique et pour sa transmission à un utilisateur, et
- au moins une résistance shunt (1) raccordée entre les bornes d'entrée et de sortie (L1i, L10) de façon à générer via la résistance shunt (1) une première tension proportionnelle au courant fourni par la phase (L1),
- un dispositif (3, 5) servant à déterminer une tension fournie par la phase (L1), le capteur de tension comprenant une entrée de tension, et
- un dispositif (13) servant à déterminer, à partir de la première tension et de la tension déterminée, une puissance fournie par la phase (L1),
l'appareil comprenant en outre un calculateur central de puissance (17) servant à déterminer, à partir des puissances déterminées fournies par les deux phases au moins (L1, L2), une puissance totale fournie par le système d'alimentation électrique,
l'appareil comprenant de plus, pour chacune des deux phases minimum (L1, L2), des dispositifs (11, 12) servant à séparer galvaniquement le capteur de courant (1, 2) et l'entrée du capteur de tension,
**caractérisé en ce que** les dispositifs de séparation (11, 12) sont adaptés pour opérer selon l'un de deux modes, le premier offrant une séparation galvanique et le second une connexion galvanique entre l'entrée (L1i, L2i), la sortie (L1o, L2o) ou la résistance shunt (1, 2) du dispositif permettant de déterminer le courant et l'entrée du capteur de tension.

2. Appareil selon la revendication 1, comprenant en outre une entrée supplémentaire (L1x, L2x) appelée à recevoir une tension prédéterminée, le capteur de tension étant adapté pour recevoir la tension prédéterminée lorsque les dispositifs de séparation (11, 12) opèrent selon le premier mode.

3. Appareil selon la revendication 1 ou 2, dans lequel les capteurs de tension sont adaptés pour recevoir une tension provenant de l'entrée (L1i, L2i), de la sortie (L1o, L2o) ou de la résistance shunt (1, 2) du capteur de courant, lorsque les dispositifs de séparation (11, 12) opèrent selon le second mode.

4. Appareil selon l'une des revendications précédentes, comprenant en outre, pour une phase au moins, un dispositif servant à transmettre la puissance déterminée fournie par le dispositif de détermination (13, 14) des deux phases minimum (L1, L2) au calculateur central (17), chaque dispositif de transmission comprenant des dispositifs (15, 16), tel qu'un coupleur optoélectronique, servant à séparer galvaniquement le dispositif de détermination (13, 14) et le calculateur central (17).

5. Appareil selon l'une des revendications précédentes, dans lequel le capteur de tension (3, 5) d'au moins une phase comprend un transformateur de tension doté d'un enroulement primaire (3) et d'un premier enroulement secondaire (5), l'enroulement primaire (3) recevant la tension à déterminer provenant de l'entrée (L1i) du capteur de tension, ce dernier étant adapté pour déterminer la tension provenant d'une tension générée dans le premier enroulement secondaire (5).

6. Appareil selon la revendication 5, dans lequel le transformateur de tension comprend en outre un deuxième enroulement secondaire (6) servant à alimenter le dispositif de détermination (13) de l'une des phases minimum (L1).

7. Appareil selon la revendication 5 ou 6, dans lequel le transformateur de tension comprend en outre un troisième enroulement secondaire (7) servant à alimenter le calculateur central (17).

8. Appareil selon l'une des revendications précédentes, dans lequel le capteur de tension d'au moins une phase (L1) comprend un amplificateur différentiel adapté pour transformer une différence de tension d'un premier niveau de tension à un second niveau de tension, l'amplificateur différentiel étant au moins doté d'une borne d'entrée adaptée pour recevoir la différence de tension à déterminer provenant de l'entrée du capteur de tension, ce dernier étant adapté pour déterminer la tension provenant d'une tension générée par l'amplificateur différentiel.

9. Appareil selon l'une des revendications précédentes, dans lequel la résistivité de la résistance shunt (1, 2) est comprise entre 0,000001 ohm et 1 ohm, par exemple entre 0,00001 ohm et 0,1 ohm, quoique de préférence entre 0,0001 ohm et 0,01 ohm.

10. Appareil selon la revendication 1, dans lequel le dispositif de séparation (11) comprend un commutateur à deux modes de fonctionnement, l'un offrant une connexion galvanique entre les entrées (L1i, L1x) et l'autre offrant une séparation galvanique des entrées (L1i, L1x).

11. Méthode de fonctionnement de l'appareil selon l'une des revendications précédentes, cette méthode comprenant :
pour chacune des deux phases au moins, lorsque les dispositifs de séparation opèrent selon le premier mode :
- la fourniture d'une tension prédéterminée à l'entrée du capteur de tension et l'étalonnage ou l'essai du capteur de tension, et/ou
- la fourniture d'un courant prédéterminé via la résistance shunt du capteur de courant et l'étalonnage ou l'essai du capteur de courant, et
- lorsque les dispositifs de séparation opèrent selon le second mode :
- pour chaque phase :
- la fourniture d'une tension et d'un courant via la phase,
- la détermination du courant à l'aide du capteur de courant,
- la détermination de la tension à l'aide du capteur de tension,
- la détermination, à l'aide du dispositif servant à déterminer la puissance, de la puissance fournie par la phase,
- la détermination, à l'aide du calculateur central, de la puissance totale fournie par les deux phases au moins.

12. Méthode selon la revendication 11, dans laquelle l'étalonnage comprend, pour chaque phase :
- l'analyse de la sortie des capteurs de courant et de tension,
- la production de données d'étalonnage sur la base de l'analyse,
- l'utilisation des données d'étalonnage dans le dispositif servant à déterminer la puissance ou dans le calculateur central,
- l'introduction des données produites dans le dispositif servant à déterminer la puissance ou dans le calculateur central.

13. Méthode selon la revendication 11 ou 12, dans laquelle la tension prédéterminée est comprise entre 105 et 500 V, par exemple entre 105 et 125 V ou entre 230 et 250 V.

14. Méthode selon l'une des revendications 11 à 13, dans laquelle le courant prédéterminé est compris entre 25 mA et 80 A.

15. Méthode selon l*'*une des revendications 11 à 14, dans laquelle le courant prédéterminé est fourni à une tension indépendante de la tension prédéterminée.
